(19) Europäisches Patentamt
European Patent Office
Office européen des brevets

(11) **EP 2 872 263 B1**

(12) **EUROPÄISCHE PATENTSCHRIFT**

(45) Veröffentlichungstag und Bekanntmachung des Hinweises auf die Patenterteilung:
**07.06.2023 Patentblatt 2023/23**

(21) Anmeldenummer: **13735037.7**

(22) Anmeldetag: **10.07.2013**

(51) Internationale Patentklassifikation (IPC):
**B06B 1/02** *(2006.01)* **G01R 19/10** *(2006.01)*
**H02M 1/12** *(2006.01)* **H03H 7/42** *(2006.01)*

(52) Gemeinsame Patentklassifikation (CPC):
**G01R 19/10; B06B 1/0207; B06B 1/0253;**
**H02M 1/126; H03H 7/425;** B06B 2201/72;
B29L 2009/00; G01R 15/185; H03H 7/1775

(86) Internationale Anmeldenummer:
**PCT/EP2013/064626**

(87) Internationale Veröffentlichungsnummer:
**WO 2014/012834 (23.01.2014 Gazette 2014/04)**

(54) **AUSGANGSSTUFE ZUR ANPASSUNG EINES WECHSELSPANNUNGSSIGNALS EINES ULTRASCHALLGENERATORS**

OUTPUT STAGE FOR ADAPTING AN ALTERNATING ELECTRICAL SIGNAL OF AN ULTRASOUND GENERATOR

ÉTAGE DE SORTIE POUR L'ADAPTATION D'UN SIGNAL ELECTRIQUE ALTERNATIF D'UN GENERATEUR ULTRASONORE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.07.2012 DE 102012106382**

(43) Veröffentlichungstag der Anmeldung:
**20.05.2015 Patentblatt 2015/21**

(73) Patentinhaber: **Herrmann Ultraschalltechnik GmbH & Co. Kg**
**76307 Karlsbad (DE)**

(72) Erfinder: **JURZITZA, Dieter**
**76131 Karlsruhe (DE)**

(74) Vertreter: **WSL Patentanwälte Partnerschaft mbB Kaiser-Friedrich-Ring 98**
**65185 Wiesbaden (DE)**

(56) Entgegenhaltungen:
**WO-A2-2012/163919 WO-A2-2013/017452**
**CH-A- 272 868 DE-A1-102006 056 095**
**US-A- 5 394 047**

EP 2 872 263 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft eine Ausgangsstufe zur Anpassung eines Ausgangssignals eines Ultraschallgenerators an einen Konverter einer Ultraschallschwingeinheit.

Ultraschallgeneratoren sind bekannt und werden beispielsweise verwendet, um eine Ultraschallschwingeinheit anzutreiben. Typische Ultraschallschwingeinheiten bestehen aus einem Konverter und einer gegebenenfalls über einen Amplitudentransformator mit diesem verbundene Sonotrode. Der Ultraschallgenerator dient dazu, ein entsprechendes Wechselspannungs- oder Wechselstromsignal zu erzeugen, welches von dem Konverter in eine mechanische Schwingung umgewandelt wird, mit der die Ultraschallschwingeinheit schwingt.

Eine solche Ultraschallschwingeinheit kann beispielsweise zum Ultraschallschweißen verwendet werden. Wesentlich ist dabei, dass die Ultraschallschwingeinheit mit ihrer Resonanzfrequenz angeregt wird.

Der Ultraschallgenerator muss folglich in der Lage sein, ein entsprechendes Wechselstromsignal zu erzeugen. Daher müssen Ultraschallgenerator und Konverter der Ultraschallschwingeinheit aufeinander abgestimmt sein. Für diese Abstimmung wird eine Ausgangsstufe verwendet, die mit dem Ultraschallgenerator verbunden sein kann oder sogar in das Generatorgehäuse integriert sein kann. Auch eine Integration in den Konverter wäre grundsätzlich denkbar.

Kernstück der Ausgangsstufe ist ein Ausgangsübertrager, d.h. die Ausgangsstufe hat zwei Eingangsanschlüsse für die Aufnahme der vom Ultraschallgenerator erzeugten Wechselspannung und zwei Ausgangsanschlüsse für die Abgabe einer angepassten Wechselspannung sowie einen Ausgangsübertrager mit einer Primärspule mit einer Anzahl $n_1$ Windungen und einer Sekundärspule mit einer Anzahl $n_2$-Windungen, wobei die beiden Eingangsanschlüsse über die Primärspule und die beiden Ausgangsanschlüsse über die Sekundärspule miteinander verbunden sind.

Üblicherweise werden bei herkömmlichen Ultraschallgeneratoren Ausgangsübertrager verwendet, deren einzige Funktion darin besteht, die beschriebene Anpassung vorzunehmen.

Ausgangsstufen weisen jedoch weitere induktive Leistungsbauteile auf. Diese dienen sowohl Kompensationszwecken, um beispielsweise eine der Schwingungsamplitude proportionale Größe ableiten zu können, sodass eine Steuerung oder Regelung der Schwingungsamplitude erfolgen kann, als auch der Befilterung des Ausgangssignals der Ausgangsstufe.

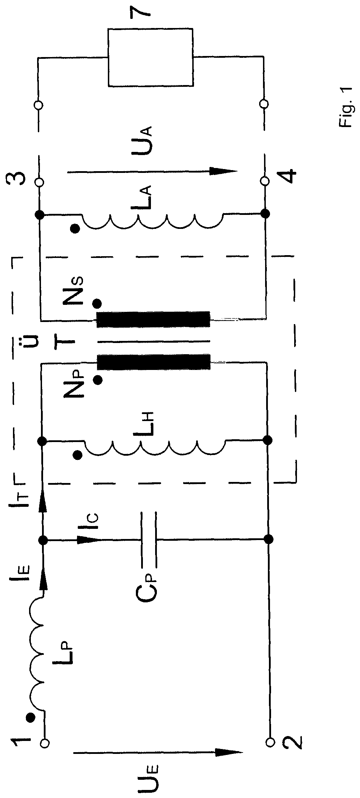

Eine Anordnung einer Ausgangsstufe des Standes der Technik ist in Figur 1 dargestellt. Die Ausgangstufe weist zwei Eingangsanschlüsse 1, 2 auf, an dem die vom Generator erzeugte Wechselspannung angelegt wird.

Die Primärspule $N_P$ und die Sekundärspule $N_S$ bilden eine idealen Übertrager. Die beiden Ausgangsanschlüsse 3, 4 liefern die Ausgangsspannung, die dann an den Konverter 7 der Ultraschallschwingeinheit angelegt wird. Die eigentliche Anpassungsfunktion wird von dem idealen Übertrager erfüllt.

Ein vereinfachtes Ersatzschaltbild des realen Übertragers ist in der gestrichelt dargestellten Box wiedergegeben. Demnach besteht der Übertrager aus einem idealen Übertrager und einer Hauptinduktivität $L_H$. Die Hauptinduktivität $L_H$ entspricht abgesehen von einer geringen Streuung der Induktivität der Primärspule.

Parallel zur Primärspule ist hier zusätzlich eine Filterkapazität $C_P$ angeordnet, welche zusammen mit der Filterinduktivität $L_P$ dazu dient, das typischerweise rechteckförmige Ausgangssignal des Generators zu filtern. Sowohl die Filterkapazität als auch die Filterinduktivität kann im Generator oder in der Ausgangsstufe angeordnet sein. Grundsätzlich weist der reale Übertrager auch noch eine Streuinduktivität $L_\sigma$ auf. Hierbei handelt es sich um eine inhärente Eigenschaft eines jeden realen Übertragers, die an jedem Klemmenpaar wirksam wird. Es ist eine zusätzliche Induktivität, die jeder individuellen Wicklungsinduktivität in Reihe geschaltet gedacht werden muss. Sie ist nicht induktiv mit den anderen Wicklungen des betrachteten Übertragers verkoppelt. Vielmehr muss sie in ihrer Wirksamkeit auf das jeweils betrachtete Klemmenpaar beschränkt gedacht werden.

Diese Streuinduktivität hat bei den hier betrachteten Übertragern eine Größenordnung von etwa 1 % - 2 % der jeweiligen Hauptinduktivität der betrachteten Wicklung. Im Stand der Technik ist sie damit deutlich kleiner als die Filterinduktivität $L_P$ und kann daher vernachlässigt werden.

Da der an den Ausgangsanschlüssen 3, 4 anzuschließende Konverter 7 eine intrinsische Konverterkapazität aufweist, wird im Konverter oder im Ausgangsübertrager in der Regel eine entsprechende Kompensationsinduktivität $L_A$ parallel zum elektrischen Konverter angeordnet.

Für die Befilterung und Kompensation werden daher generatorseitig die Induktivität $L_P$ und der Kondensator $C_P$ sowie konverterseitig die Kompensationsinduktivität $L_A$ verwendet.

Diese zusätzlichen Elemente verteuern den Aufbau und benötigen zusätzlichen Bauraum.

Aus der DE 10 2006 056 095 A1 ist eine Schaltungsanordnung zur Auswertung und/oder zur Ansteuerung von Schallwandlern für die Anwendung in Fahrzeugen bekannt. Dabei ist auf der Sekundärseite der Schaltungsanordnung zwischen zwei Ausgängen eine Kapazität vorgesehen.

Es ist daher Aufgabe der vorliegenden Erfindung, eine Ausgangsstufe mit einem Ausgangsübertrager anzugeben, der eine kostengünstige und wenig aufbauende Anpassung eines Generatorausgangs an den Konvertereingang erlaubt.

Erfindungsgemäß wird diese Aufgabe dadurch gelöst, dass eine Filterkapazität $C_P$ vorgesehen ist, die entweder die beiden Ausgangsanschlüsse parallel zur Sekundärspule verbindet oder einen Ausgangsanschluss mit einem Abgriff der Sekundärspule verbindet oder mit einer Filterspule mit $n_3$-Windungen verbunden ist, welche mit der Primär- und der Sekundärspule induktiv gekoppelt ist.

Im Grunde genommen liegt der vorliegenden Erfindung die Erkenntnis zugrunde, dass der Ausgangsübertrager derart eingestellt werden kann, dass seine Streuinduktivität die Rolle der Filterinduktivität $L_P$ übernimmt, sodass auf das separate zur Verfügung stellen der Filterinduktivität $L_P$ verzichtet werden kann.

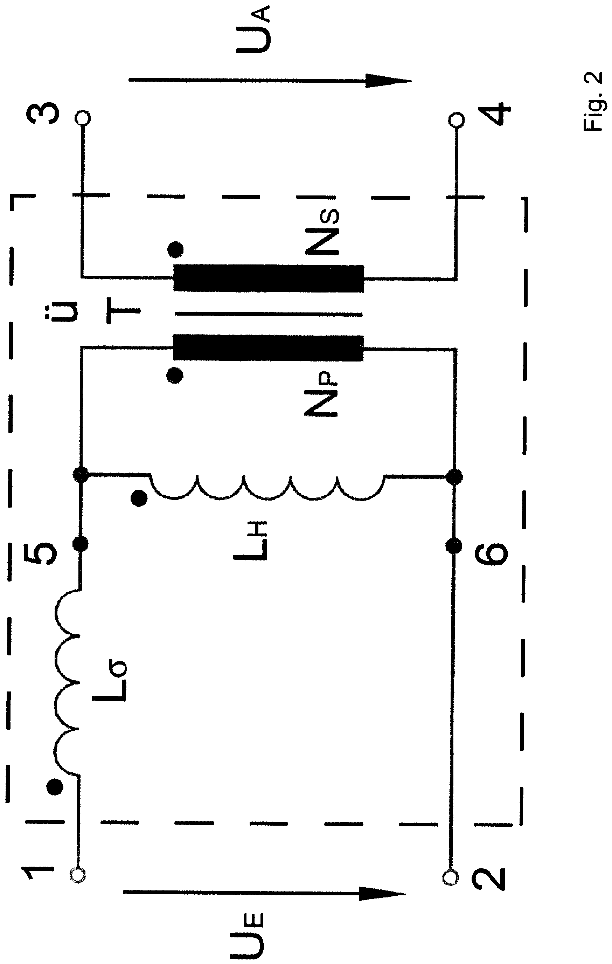

In Figur 2 ist ein erweitertes Ersatzschaltbild eines Ausgangsübertragers gezeigt. Der Ausgangsübertrager kann durch einen idealen Übertrager T mit einem entsprechenden Übersetzungsverhältnis ü dargestellt werden. Parallel zur Primärspule $N_P$ liegt die Hauptinduktivität $L_H$, die im Wesentlichen der Induktivität der Primärspule entspricht. Die eingezeichnete Induktivität $L_\sigma$ stellt die Streuinduktivität dar. Die Streuinduktivität $L_\sigma$ soll in dem gezeigten Beispiel sowohl die Streuinduktivität der Primärspule als auch die Streuinduktivität der Sekundärspule umfassen. Wie bereits ausgeführt ist die Streuinduktivität normalerweise gering, so dass sie vernachlässigt werden kann.

Durch geeignete Dimensionierung des Ausgangsübertragers kann nun die Streuinduktivität $L_\sigma$ so eingestellt werden, dass sie der gewünschten Filterinduktivität $L_P$ entspricht, die dadurch entfallen kann.

Es versteht sich jedoch, dass an den in Figur 2 dargestellten Punkten 5 und 6, d.h. parallel zur Induktivität $L_H$ die gewünschte Filterkapazität $C_P$ nicht angeordnet werden kann, da die Induktivitäten $L_H$ und $L_\sigma$ keine realen Bauteile, sondern lediglich Elemente des Ersatzschaltbildes und daher intrinsische Eigenschaften des realen Ausgangsübertragers sind. Tatsächlich stellt das in der gestrichelten Box dargestellte Ersatzschaltbild ein einziges Element dar.

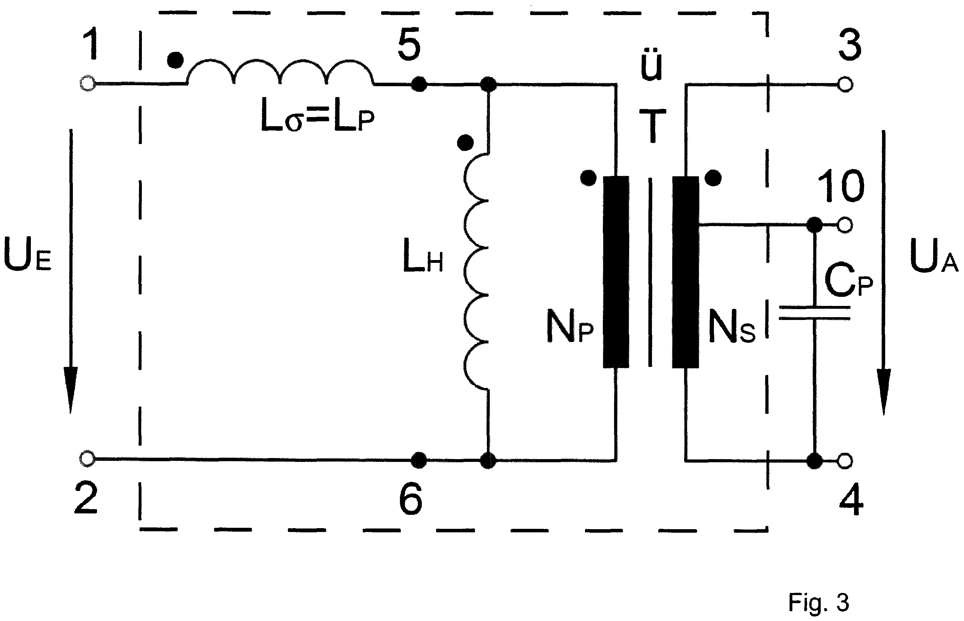

Erfindungsgemäß wird nun die Filterkapazität $C_P$ nicht primärseitig sondern sekundärseitig vorgesehen. Beispielsweise kann, wie in Figur 3 dargestellt ist, die Sekundärspule ein Abgriff 10 aufweisen, sodass die Filterkapazität $C_P$ zwischen Abgriff 10 und Ausgangsanschluss 4 geschaltet werden kann. Die sekundärseitige Anordnung des Filterkondensators $C_P$ führt schlussendlich zum gleichen Verhalten des Ausgangsübertragers, wie in Figur 1 dargestellt ist, wobei jetzt jedoch die Funktion der separaten Filterinduktivität $L_P$ von der ohnehin vorhandenen und erfindungsgemäß absichtlich größer eingestellten Streuinduktivität $L_\sigma$ übernommen wird. Dadurch kann ein physikalisches Bauteil eingespart werden.

Es sei an dieser Stelle erwähnt, dass die Wicklungskapazität des Ausgangsübertragers bei der Überlegung nicht berücksichtigt wurde. Dies ist jedoch gerechtfertigt, da die Filterkapazität $C_P$ um ein Vielfaches größer ist als die Wicklungskapazität.

In der Regel ist es hilfreich, wenn der Strom $I_T$, d.h. der durch den Ausgangsübertrager fließende Strom gemessen wird, da er ein Maß für die Schwingungsamplitude der Ultraschallschwingeinheit darstellt. In der in Figur 1 gezeigten bekannten Ausführungsform lässt sich dieser Strom einfach messen. Es gilt $I_E = I_T + I_C$. Mit anderen Worten teilt sich der an den Eingangsanschlüssen 1, 2 eingespeiste Strom in einen Strom durch den Ausgangsübertrager $I_T$ und den Strom Ic über die Filterkapazität $C_P$ auf. Bei der erfindungsgemäß vorgesehenen Lösung, bei der die Filterinduktivität $L_P$ durch die Streuinduktivität $L_\sigma$ verwirklicht wird, kann jedoch der Strom $I_T$ nicht mehr direkt gemessen werden.

Erfindungsgemäß ist daher vorgesehen, dass eine Einrichtung zur Messung des Differenzstromes $I_\Delta$ aus dem über die Eingangsanschlüsse fließenden Strom $I_E$ und dem Strom Ic durch die Filterkapazität $C_P$ vorgesehen ist. Mit anderen Worten wird nun von dem Eingangsstrom $I_E$ der durch die sekundärseitig angebrachte Filterkapazität $C_P$ fließende Strom abgezogen. Der Differenzstrom $I_\Delta$ entspricht aber dem Strom $I_T$.

Diese Differenzmessung kann beispielsweise mit Hilfe eines induktiven Strommesswandlers erfolgen, durch den sowohl eine Leitung, durch welche der über den Eingangsanschluss fließende Strom $I_E$ fließt, als auch eine Leitung, durch welche der Strom $I_C$ durch die Filterkapazität $C_P$ fließt, geführt ist. Es versteht sich, dass die entsprechenden Leitungen dann entgegengesetzt durchflossen werden, um die Differenzbildung zu gewährleisten.

Ist das Verhältnis n1 zu n2 gleich 1, wird in einer bevorzugten Ausführungsform die Filterkapazität $C_P$ derart angeordnet, dass sie die beiden Ausgangsanschlüsse 3,4 parallel zur Sekundärspule verbindet und CP n1 Windungen überbrückt.

Für den Fall, dass das Verhältnis n1 zu n2 kleiner als 1 ist, wird in einer bevorzugten Ausführungsform die Filterkapazität $C_P$ derart angeordnet, dass sie einen Ausgangsanschluss mit einem Abgriff der Sekundärseite verbindet, wobei der Abgriff nach n1 Windungen angeordnet ist, der Kondensator $C_P$ auf der Sekundärseite also n1 Windungen überbrückt.

Alternativ dazu wäre es auch möglich, dass die Filterkapazität $C_P$ mit einer Filterspule mit $n_3$-Windungen verbunden ist, wobei $n_3 = n_1$ ist. Diese Filterspule muss dann mit der Primär- und Sekundärspule induktiv gekoppelt sein.

Auf diese Weise ist wieder sichergestellt, dass die Kapazität 1:1 von der Primärseite auf die Sekundärseite übertragen wird und in vollständiger Analogie zur Figur 1 die benötigte Parallelkapazität $C_P$ zur Hauptinduktivität $L_H$ bildet.

Diese bevorzugten Ausführungsformen machen es besonders einfach, die beschriebene Differenzbildung des Stromes zu realisieren. Bei anderen Übersetzungsverhältnissen für den Anschluss von $C_P$ ist es denkbar, vielfache des Stromes durch $C_P$ vom Strom $I_E$ abzuziehen, um das gleiche Ergebnis zu erzielen. In einer bevorzugten Ausführungsform könnte dies durch mehrfache Durchführung des den Strom durch $C_P$ führenden Drahtes durch den induktiven Strommesswandler verwirklicht werden. Der Wert von $C_P$ ist dann entsprechend dem Übersetzungsverhältnis und der sich ergebenden Streuinduktivität geeignet anzupassen.

Die vorliegende Erfindung betrifft des weiteren eine Ultraschallschweißanordnung mit einer Ultraschallschwingeinheit, einem Ultraschallgenerator und der erfindungsgemäßen Ausgangsstufe, wobei die Ultraschallschwingeinheit einen Wandler zur Umwandlung eines elektrischen Wechselstroms in eine mechanische Schwingung aufweist. In einer bevorzugten Ausführungsform ist dann vorgesehen, dass der Ultraschallgenerator dafür ausgelegt ist, ein elektrisches Signal der Frequenz f zu erzeugen, dass der Konverter eine Konverterkapazität $C_K$ aufweist und dass die Hauptinduktivität $L_H$ derart gewählt wird, dass die Hauptinduktivität zusammen mit der Konverterkapazität einen Sperrkreis bildet, dessen Sperrfrequenz fs im Wesentlichen der Frequenz f entspricht.

Alternativ oder in Kombination hierzu wird die Filterkapazität $C_P$ so gewählt, dass $\dfrac{1}{2\pi C_p L_\sigma}$ zwischen dem 1,5 fachen und dem 2,5 fachen der Frequenz f beträgt.

Mit anderen Worten übernimmt nicht nur die Streuinduktivität $L_\sigma$ die Funktion der üblicherweise primärseitig angeordneten Filterinduktivität $L_P$, sondern die Hauptinduktivität $L_H$ übernimmt zusätzlich die Funktion der Kompensationsinduktivität $L_A$, die sekundärseitig im Konverter bereitgestellt wird.

Durch diese Anordnung können zwei Induktivitäten im Generator eingespart werden.

Weitere Vorteile, Merkmale und Anwendungsmöglichkeiten der vorliegenden Erfindung werden deutlich anhand der folgenden Beschreibung einer bevorzugten Ausführungsform und der zugehörigen Figuren. Es zeigen:

Figur 1 einen Ausgangsübertrager des Standes der Technik,
Figur 2 ein Ersatzschaltbild eines Transformators,
Figur 3 eine Ausführungsform der Erfindung und
Figur 4 eine Ausführungsform einer Strommessvorrichtung.

Figur 1 zeigt einen Schaltplan einer Generatorausgangsstufe des Standes der Technik. Der Aufbau wurde bereits in der Einleitung erläutert.

In Figur 2 ist ein Ersatzschaltbild eines Ausgangsübertragers ohne induktive oder kapazitive Leistungsbauteile gezeigt. Der Aufbau wurde bereits in der Beschreibungseinleitung erläutert.

In Figur 3 ist eine erste Ausführungsform der Erfindung gezeigt. Dargestellt ist das Ersatzschaltbild des Ausgangsübertragers. Dieses Ersatzschaltbild entspricht im Wesentlichen dem Bild von Figur 2, wobei jedoch nun die Hauptinduktivität $L_H$ und die Streuinduktivität $L_\sigma$ so variiert worden sind, dass die Hauptinduktivität $L_H$ einen Wert annimmt, der mit der Kompensationsinduktivität $L_A$ übereinstimmt, die im Konverter üblicherweise verwendet wird. Durch diese Maßnahme kann auf die Verwendung einer separaten Induktivität im Konverter verzichtet werden. Des weiteren ist die Streuinduktivität $L_\sigma$ derart gewählt worden, dass sie der Filterinduktivität $L_P$ von Figur 1 entspricht, sodass auch auf die Filterinduktivität verzichtet werden kann. Da die Filterinduktivität $L_P$ in der gezeigten Ausführungsform durch die Streuinduktivität $L_\sigma$ verwirklicht wird, kann der Filterkondensator $C_P$ nicht an der in Figur 1 gezeigten Position angeordnet werden, da ein entsprechender Abgriff nicht zur Verfügung steht.

Daher wird erfindungsgemäß vorgeschlagen, die Filterkapazität $C_P$ sekundärseitig, wie in Figur 3 gezeigt ist, anzuordnen. In der gezeigten Ausführungsform weist die sekundärseitige Spule Ns einen Abgriff $N_P$ auf, sodass die Filterkapazität $C_P$ den Abgriff 10 mit einem Ausgangsanschluss 4 verbindet. Der Abgriff 10 ist bei der gezeigten Ausführungsform bei einer Windungszahl angeordnet, die der Windungszahl der Primärspule entspricht.

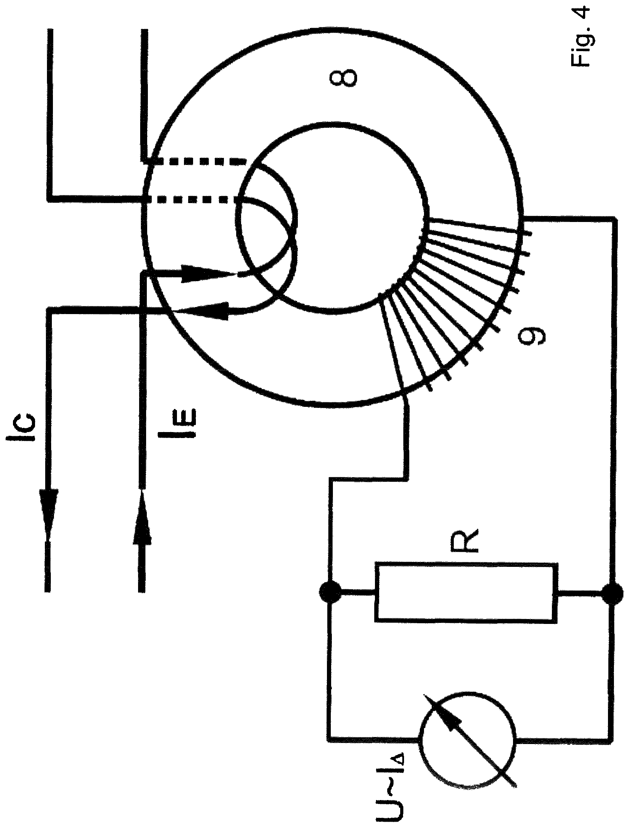

Um nun den Strom zu messen, der proportional zur Schwingungsamplitude der Ultraschallschwingeinheit ist, wird ein induktiver Strommesswandler 8,9 verwendet, wie er in Figur 4 gezeigt ist. Dieser induktive Strommesswandler wird zwischen der Filterkapazität $C_P$ und der primären Hauptinduktivität eingefügt. Der Strommesswandler besteht aus einem kleinen Ringkerntransformator, bei welchem der zu messende Strom durch ein Loch im Kern 8 hindurchgeführt wird. Wie in Figur 4 zu erkennen ist, wird sowohl der durch den Filterkondensator $C_P$ fließende Kondensatorstrom $I_C$ als auch der Gesamteingangsstrom $I_E$ durch den Strommesswandler geführt, jedoch mit umgekehrtem Vorzeichen, sodass mit Hilfe der Anordnung die Differenz zwischen den beiden Größen gemessen werden kann, welche proportional zur Schwingungsamplitude ist.

**Bezugszeichenliste**

| | |
|---|---|
| 1, 2 | Eingangsanschlüsse |
| 3, 4 | Ausgangsanschlüsse |
| 5, 6 | Punkte |
| 7 | Konverter |
| 8 | Kern des Strommesswandlers |
| 9 | Spule des Strommesswandlers |
| 10 | Abgriff |
| $N_P$ | Primärspule |
| $N_S$ | Sekundärspule |
| $C_P$ | Filterkapazität, Kondensator |
| $L_A$ | Kompensationsinduktivität |

$L_H$     Hauptinduktivität
$L_\sigma$     Streuinduktivität
$L_P$     Filterinduktivität
$I_T$     Transformatorstrom
$I_E$     Eingangsstrom
$I_C$     Kondensatorstrom

**Patentansprüche**

1.  Ausgangsstufe zur Anpassung eines Wechselspannungssignals eines Ultraschallgenerators an einen an die Ausgangsstufe anschließbaren Konverter (7), wobei die Ausgangsstufe zwei Eingangsanschlüsse (1, 2) für die Aufnahme der vom Ultraschallgenerator erzeugten Wechselspannung und zwei Ausgangsanschlüsse (3, 4) für die Abgabe einer angepassten Wechselspannung sowie einen Ausgangsübertrager mit einer Primärspule ($N_P$) mit einer Anzahl $n_1$ Windungen und einer Sekundärspule ($N_S$) mit einer Anzahl $n_2$ Windungen aufweist, wobei der Ausgangsübertrager eine Hauptinduktivität $L_H$ sowie eine Streuinduktivität $L_\sigma$ hat, wobei die beiden Eingangsanschlüsse (1, 2) über die Primärspule ($N_P$) und die beiden Ausgangsanschlüsse (3, 4) über die Sekundärspule ($N_S$) miteinander verbunden sind, wobei eine Filterkapazität $C_P$ vorgesehen ist, die entweder die beiden Ausgangsanschlüsse (3, 4) parallel zur Sekundärspule (Ns) verbindet oder einen Ausgangsanschluss (3, 4) mit einem Abgriff (10) der Sekundärspule (Ns) verbindet oder mit einer Filterspule mit $n_3$ Windungen verbunden ist, welche mit der Primär- und der Sekundärspule ($N_P$, Ns) induktiv gekoppelt ist, **dadurch gekennzeichnet, dass** eine Einrichtung zur Messung des Differenzstromes $I_\Delta$ aus dem über die Eingangsanschlüsse (1, 2) fließenden Strom $I_E$ und dem Strom Ic durch die Filterkapazität $C_P$ vorgesehen ist.

2.  Ausgangsstufe nach Anspruch 1, **dadurch gekennzeichnet, dass** als Einrichtung zur Messung des Differenzstromes $I_\Delta$ ein induktiver Strommesswandler verwendet wird, durch den sowohl eine Leitung durch welche der über die Eingangsanschlüsse (1, 2) fließende Strom $I_E$ fließt, als auch eine Leitung, durch welche der Strom Ic durch die Filterkapazität $C_P$ fließt, geführt ist.

3.  Ausgangsstufe nach einem der Ansprüche 1 bis 2, **dadurch gekennzeichnet, dass** das Verhältnis $n_1$ zu $n_2$ gleich Eins ist ($\frac{n_1}{n_2} = 1$) und die Filterkapazität $C_P$ derart angeordnet ist, dass sie die beiden Ausgangsanschlüsse (3, 4) parallel zur Sekundärspule (Ns) verbindet.

4.  Ausgangsstufe nach einem der Ansprüche 1 bis 2, **dadurch gekennzeichnet, dass** das Verhältnis $n_1$ zu $n_2$ kleiner Eins ist ($\frac{n_1}{n_2} < 1$) und die Filterkapazität $C_P$ derart angeordnet ist, dass sie einen Ausgangsanschluss (3, 4) mit einem Abgriff der Sekundärspule (Ns) verbindet, wobei der Abgriff nach $n_1$ Wicklungen angeordnet ist.

5.  Ausgangsstufe nach einem der Ansprüche 1 bis 2, **dadurch gekennzeichnet, dass** die Filterkapazität $C_P$ mit einer induktiv mit dem Ausgangsübertrager gekoppelten Filterspule mit $n_3$ Windungen verbunden ist, wobei gilt $n_3 = n_1$.

6.  Ultraschallschweißanordnung mit einer Ultraschallschwingeinheit, einem Ultraschallgenerator sowie einer Ausgangsstufe nach einem der Ansprüche 1 bis 5, **dadurch gekennzeichnet, dass** die Ultraschallschwingeinheit einen Wandler (7) zur Umwandlung eines elektrischen Wechselstroms in eine mechanische Schwingung aufweist, und der Ultraschallgenerator dafür ausgelegt ist, ein elektrisches Signal der Frequenz f zu erzeugen.

7.  Ultraschallschweißanordnung nach Anspruch 6, **dadurch gekennzeichnet, dass** der Wandler (7) eine Konverterkapazität $C_K$ aufweist und dass die Hauptinduktivität $L_H$ des Ausgangsübertragers derart gewählt wird, dass die Hauptinduktivität zusammen mit der Konverterkapazität einen Sperrkreis bildet, dessen Sperrfrequenz fs im wesentlichen f entspricht.

8.  Ultraschallschweißanordnung nach Anspruch 6 oder 7, **dadurch gekennzeichnet, dass** die Filterkapazität $C_P$ so gewählt wird, dass $\frac{1}{2\pi C_p L_\sigma}$ zwischen dem 1,5 fachen und dem 2,5 fachen der Frequenz f beträgt.

**Claims**

1.  An output stage for adapting an alternating voltage signal of an ultrasound generator to a converter (7) which can be connected to the output stage, wherein the output stage has two input terminals (1, 2) for receiving the alternating voltage produced by the ultrasound generator and two output terminals (3, 4) for outputting an adapted alternating voltage, as well as an output transformer with a primary coil (Nr) with a number $n_1$ of turns and a secondary coil (Ns) with a number $n_2$ of turns, wherein the output transformer has a main inductance $L_H$ as well as a leakage in-

ductance $L_\sigma$, wherein the two input terminals (1, 2) are connected to one another via the primary coil ($N_P$) and the two output terminals (3, 4) are connected to one another via the secondary coil ($N_S$), wherein a filter capacitor $C_P$ is provided which either connects the two output terminals (3, 4) to the secondary coil (Ns) in parallel or connects one output terminal (3, 4) to a tap (10) of the secondary coil (Ns) or is connected to a filter coil with $n_3$ turns which is inductively coupled to the primary and the secondary coil ($N_P$, $N_S$), **characterized in that** a device is provided for measuring the differential current $I_\Delta$ of the current $I_E$ flowing via the input terminals (1, 2) and the current $I_C$ through the filter capacitor $C_P$.

2. The output stage according to claim 1, **characterized in that** an inductive current measuring transformer is used as the device for measuring the differential current $I_\Delta$, through which both a line through which the current $I_E$ flowing via the input terminals (1, 2) flows as well as a line through which the current $I_C$ flows through the filter capacitor $C_P$ are guided.

3. The output stage according to one of claims 1 to 2, **characterized in that** the ratio of $n_1$ to $n_2$ is equal to one ( $\frac{n_1}{n_2} = 1$ ) and the filter capacitor $C_P$ is disposed in a manner such that it connects the two output terminals (3, 4) in parallel to the secondary coil (Ns).

4. The output stage according to one of claims 1 to 2, **characterized in that** the ratio of $n_1$ to $n_2$ is less than one ( $\frac{n_1}{n_2} < 1$ ) and the filter capacitor $C_P$ is disposed in a manner such that it connects one output terminal (3, 4) to a tap of the secondary coil ($N_S$), wherein the tap is disposed after $n_1$ turns.

5. The output stage according to one of claims 1 to 2, **characterized in that** the filter capacitor $C_P$ is connected to a filter coil with $n_3$ turns which is inductively coupled to the output transformer, wherein $n_3 = n_1$ holds.

6. An ultrasonic welding assembly with an ultrasonic vibration unit, an ultrasonic generator as well as an output stage according to one of claims 1 to 5, **characterized in that** the ultrasonic vibration unit has a converter (7) for converting an alternating electric current into a mechanical vibration, and the ultrasonic generator is configured to produce an electric signal with frequency f.

7. The ultrasonic welding assembly according to claim 6, **characterized in that** the converter (7) has a converter capacitance $C_K$ and **in that** the main inductance $L_H$ of the output transformer is selected in a manner such that the main inductance together with the converter capacitance forms a blocking circuit the blocking frequency $f_s$ of which substantially corresponds to f.

8. The ultrasonic welding assembly according to claim 6 or claim 7, **characterized in that** the filter capacitor $C_P$ is selected in a manner such that $\frac{1}{2\pi C_P L_\sigma}$ is between 1.5 times and 2.5 times the frequency f.

**Revendications**

1. Étage de sortie pour adapter un signal de tension alternative d'un générateur d'ultrasons à un convertisseur (7) pouvant être raccordé à l'étage de sortie, l'étage de sortie comprenant deux raccords d'entrée (1, 2) pour recevoir la tension alternative générée par le générateur d'ultrasons et deux raccords de sortie (3, 4) pour délivrer en sortie une tension alternative adaptée, ainsi qu'un transformateur de sortie comprenant une bobine primaire ($N_P$) comprenant un nombre $n_1$ de spires et une bobine secondaire (Ns) comprenant un nombre $n_2$ de spires, le transformateur de sortie présentant une inductance principale $L_H$ et une inductance de fuite $L_\sigma$, les deux raccords d'entrée (1, 2) étant reliés l'un à l'autre par l'intermédiaire de la bobine primaire (Nr) et les deux raccords de sortie (3, 4) étant reliés l'un à l'autre par l'intermédiaire de la bobine secondaire ($N_S$), un condensateur de filtrage $C_P$ étant prévu, qui relie les deux raccords de sortie (3, 4) en parallèle à la bobine secondaire (Ns), ou relie un raccord de sortie (3, 4) à une prise (10) de la bobine secondaire (Ns), ou est relié à une bobine de filtrage avec $n_3$ spires, qui est couplée par induction aux bobines primaire et secondaire (Nr, Ns), **caractérisé en ce qu'**un dispositif est prévu pour mesurer le courant différentiel $I_\Delta$ entre le courant $I_E$ circulant à travers les raccords d'entrée (1, 2) et le courant le à travers le condensateur de filtrage $C_P$.

2. Étage de sortie selon la revendication 1, **caractérisé en ce qu'**un convertisseur de mesure de courant inductif est utilisé en tant que dispositif de mesure du courant différentiel $I_\Delta$ à travers lequel est guidée aussi bien une ligne à travers laquelle circule le courant $I_E$ circulant à travers les raccords d'entrée (1, 2), mais également une ligne à travers laquelle circule le courant le à travers le condensateur de filtrage $C_P$.

3. Étage de sortie selon l'une quelconque des revendications 1 à 2, **caractérisé en ce que** le rapport $n_1$

$$\frac{n_1}{n_2} = 1$$

sur nz est égal à un ( ) et le condensateur de filtrage $C_P$ est agencé de manière à relier les deux raccords de sortie (3, 4) en parallèle à la bobine secondaire (Ns).

4. Étage de sortie selon l'une quelconque des revendications 1 à 2, **caractérisé en ce que** le rapport $n_1$

$$\frac{n_1}{n_2} < 1$$

sur $n_2$ est inférieur à un ( ) et le condensateur de filtrage $C_P$ est agencé de manière à relier un raccord de sortie (3, 4) à une prise de la bobine secondaire (Ns), la prise étant agencée après $n_1$ enroulements.

5. Étage de sortie selon l'une quelconque des revendications 1 à 2, **caractérisé en ce que** le condensateur de filtrage Cr est relié à une bobine de filtrage avec $n_3$ spires couplée par induction au transformateur de sortie, avec $n_3 = n_1$.

6. Ensemble de soudage par ultrasons comprenant une unité d'oscillation par ultrasons, un générateur d'ultrasons et un étage de sortie selon l'une quelconque des revendications 1 à 5, **caractérisé en ce que** l'unité d'oscillation par ultrasons comprend un convertisseur (7) pour convertir un courant électrique alternatif en une oscillation mécanique, et que le générateur d'ultrasons est conçu pour générer un signal électrique de fréquence f.

7. Ensemble de soudage par ultrasons selon la revendication 6, **caractérisé en ce que** le convertisseur (7) comprend un condensateur de conversion $C_K$ et **en ce que** l'inductance principale $L_H$ du transformateur de sortie est choisie de telle manière que l'inductance principale forme conjointement avec le condensateur de conversion un circuit bouchon dont la fréquence de coupure $f_S$ correspond sensiblement à f.

8. Ensemble de soudage par ultrasons selon la revendication 6 ou 7, **caractérisé en ce que** le condensateur de filtrage Cr est choisi de telle sorte que

$$\frac{1}{2\pi C_P L_\sigma}$$ est de 1,5 fois à 2,5 fois la fréquence f.

Fig. 1

Fig. 2

EP 2 872 263 B1

Fig. 3

Fig. 4

EP 2 872 263 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006056095 A1